# EUROPEAN PATENT APPLICATION

(11) **EP 1 883 120 A2**
(43) Date of publication of application: **30.01.2008**
(21) Application number: 07112933.2
(22) Date of filing: 23.07.2007
(51) Int. Cl.: H01L 33/00

(54) **LED substrate**

(30) Priority: 28.07.2006 KR 20060020409 U
(71) Applicant: Gia Tzoong Enterprise Co. Ltd., 330 Taoyuan (TW)
(72) Inventor: Tseng, Chi-Li, Taipei 112 (TW); Chang, Shang-Fu, Taoyuan County 320 (TW); Yeh, Tzu-Li, Taipei County 243 (TW)
(74) Representative: Beck, Michael Rudolf

(57) **Abstract**

A liquid crystal display (LCD) has an LED substrate comprising a base layer (10), a heat conductive layer (11), an electrical conductive layer (12) and a light emitting diode (13). With the substrate, heat is well dissipated. The substrate can be easily manufactured. And, thus, the cost for the LCD is reduced.

## Description

### Field of the invention

The present invention relates to a liquid crystal display (LCD); more particularly, relates to improving a dissipation efficiency of the LCD, simplifying a process for manufacturing the LCD and thus reducing a cost for the LCD.

### Description of the Related Art(s)

For a flat display, the main stream is a thin-film transistor (TFT) LCD, which is used in a computer, a mobile phone and, especially, a liquid crystal television.

The TFT LCD is not self-luminescent and so requires a back light. For now, a back light is mainly a cold cathode fluorescent lamp (CCFL). However, CCFL includes mercury and so has an environmental problem. Additionally, its brightness and color representation do not satisfy all users' requests, and so a new back light becomes important. The new back light should meet requirements for a high brightness and a good color representation with an improved color purity through a color filter, an improved structure for film transistor and an improved backlight module.

The backlight module can be a direct-type lighting with CCFL, a side-type lighting with CCFL or a side-type lighting with light emitting diode (LED). The direct-type lighting with CCFL is used in a liquid crystal television (LCTV) and a LCD above 19" (inch); the side-type lighting with CCFL, a LCD below 19" and a notebook computer; and, the side-type lighting with LED, a middle-small mobile phone and a PDA.

The direct-type lighting module with CCFL has its light source at panel's back. Because the CCFL is vertically set, some problems is under consideration: the gravity of the CCFL, the electromagnetic interference from the dense CCFL and the heat dissipation. Most of these problems have been solved, and so backlight module is widely used in LCTV's panels.

Because LCTV emphasizes on color representation in hope to bring most real color to the watcher, demands on color saturation get higher and higher. LED becomes the future owing to its wide color gamut and deprivation of mercury pollution. Sony and Lumileds successfully develop 40" and 46" LCTVs with LED backlights, started selling at November, 2004.

Concerning the LCTVs with LED backlight module, the 40" LCTV uses 325 LED modules and the 46" LCTV used 450 LED modules. The most serious problem on using LEDs is the heat dissipation. On designing the panel, fans are added to solve the heat dissipation problem of LED. If the problem is not well solved, the whole module may become unstable. As a result, the power consumes by the fans is much more than that by LEDs. Besides power consumption, a great number of LEDs used in a large-scale LCTV is another consideration concerning cost. For most consumer, they want to spend less money to purchase higher satisfaction. Thus, for LCTV producer, the above problems have to be solved for a bigger market.

About an external electrode fluorescent lamp (EEFL), its electrodes are designed outside of the lamp, what makes it different from a traditional lamp. Hence, an inverter can be designed to switch multiple lamps, while traditional lamps have to have their own inverters separately. By doing so, electrodes is not be polluted by metal sputtering resulting in wasting, and the lamp can have a higher lighting efficiency. In addition, an outside electrode design may have less gas leakage and so the lamp can have a longer life-time. Yet, a problem now is that the best driving waveform for the outside electrode is not certain and a proper inverter is not developed, and so a high tube current is not achieved. Moreover, space design has to put into consideration because of the outside electrode.

On developing backlight source module, flat fluorescent lamp (FFL) is a hit. A traditional CCFL is a linear light source. For demands on brightness and uniformity for a large-scale liquid crystal panel, design of a backlight module have to consider number of the lamps and arrangement in structure to achieve a certain quality. On the contrary, a flat light source has a higher luminescence and do not need a light guide plate; so its structure and assembly process is simpler. Because material for a backlight module is saved and assembly process is simplified, cost can be down for 30%. Hence, a flat light source is more competitive than the side-type or direct-type light sources in brightness and material cost.

It is believed the LED backlight will be the light source successor in the future. But, consumers will not pay for a several-times-high price to replace an old product although they are willing to try a new technology for a better quality. Hence, except the improvement made in heat dissipation, luminescence efficiency and stability, the price has to be more competitive.

As a conclusion, the above prior arts are used in backlight of LCD. But the CCFL has mercury for pollution issue and brightness and color saturation not satisfactory enough; and the backlight has a too high cost and issues about heat dissipation, luminescence efficiency and stability are not totally solved. Hence, the prior arts do not fulfill all users' requests on actual use.

### Summary of the invention

The main purpose of the present invention is to improve a dissipation efficiency of a LCD, to simplify a process for manufacturing the LCD and thus to reduce a cost for the LCD.

To achieve the above purpose, the present invention is a diode substrate of a LCD, comprising a base layer, a heat conductive layer, an electrical conductive layer and a LED, where each of the heat conductive layer and the electrical conductive layer can be a single layer or multiple layers; and the heat conductive layer and the electrical conductive layer can have a concave to be put with the LED. Accordingly, a novel diode substrate of a LCD is obtained.

### Brief descriptions of the drawings

The present invention will be better understood from the following detailed descriptions of the preferred embodiments according to the present invention, taken in conjunction with the accompanying drawings, in which
- FIG. 1: is the sectional view showing the first preferred embodiment according to the present invention;
- FIG.2: is the sectional view showing the second preferred embodiment;
- FIG.3: is the sectional view showing the third preferred embodiment; and
- FIG.4: is the sectional view showing the fourth preferred embodiment;

### Descriptions of the preferred embodiments

The following descriptions of the preferred embodiments are provided to understand the features and the structures of the present invention.

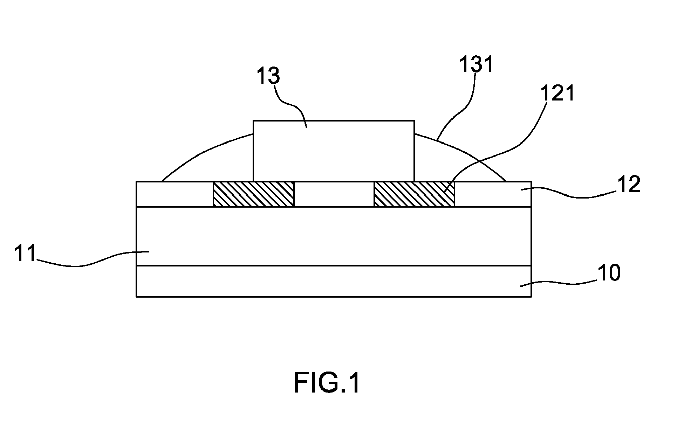

Please refer to FIG. 1, which is a sectional view showing a first preferred embodiment according to the present invention. As shown in the figure, the present invention is a diode substrate of a liquid crystal display (LCD), comprising a base layer 10, a heat conductive layer 11, an electrical conductive layer 12 and a light emitting diode (LED) 13, where a process for manufacturing the LCD is simplified and a cost for the LCD is thus reduced.

The base layer 10 is an aluminum plate, a copper plate or a copper layer with a thickness between 0.1 and 5 millimeters (mm).

The heat conductive layer 11 is deposed on a surface of the base layer 10; and is made of an insulating heat conductive glue or an insulating glue.

The electrical conductive layer 12 is deposed on a surface of the heat conductive layer 11 and has two corresponding insulating parts 121 at default positions, where the insulating part 121 is made of a solder resist material and the electrical conductive layer 12 has a thickness between 12 and 180 micrometers (um).

The LED 13 is deposed at two bottom sides of the insulating part 121 of the electrical conductive layer 12. And the LED 13 is electrically connected with the electrical conductive layer 12 through a leading wire 131 at each of the two sides.

On using, the LED 13 is provided with a required power through the electrical conductive layer 12 to make the LED 13 emit a required light source. When the LED 13 emits the light source, the LED 13 and the electrical conductive layer 12 generate heat source simultaneously. At the moment, the heat source from the electrical conductive layer 12 is absorbed by the heat conductive layer 11. Then the heat source is transmitted to the base layer 10 to be dissipated. Thus, a novel diode substrate of a LCD is obtained.

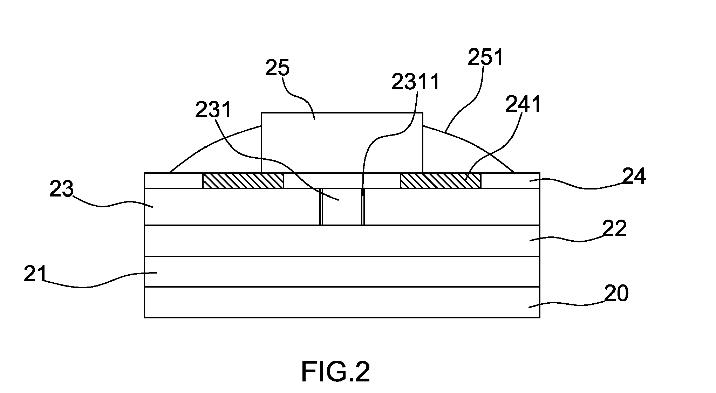

Please refer to FIG.2, which is a sectional view showing a second preferred embodiment. As shown in the figure, the present invention is a diode substrate of a LCD, comprising a base layer 20, a heat conductive layer 21, a first electrical conductive layer 22, a heat conductive sub-layer 23, a second electrical conductive layer 24 and a LED 25, where a process for manufacturing the LCD is simplified and a cost for the LCD is thus reduced.

The base layer 20 is an aluminum plate, a copper plate or a copper layer with a thickness between 0.1 and 5mm.

The heat conductive layer 21 is deposed on a surface of the base layer 20; and is made of an insulating heat conductive glue or an insulating glue.

The first electrical conductive layer 22 is deposed on a surface of the heat conductive layer 21, where the first electrical conductive layer 22 is a copper layer with a thickness between 12 and 180um.

The heat conductive sub-layer 23 is deposed on a surface of the first electrical conductive layer 22 and has a hole 231 at center, where the heat conductive sub-layer 23 is made of an insulating heat conductive glue or an insulating glue, and the wall surface of the hole 231 is plated with copper 2311 for heat dissipation.

The second electrical conductive layer 24 is deposed on a surface of the heat conductive sub-layer 23 and is connected with the first electrical conductive layer 22 through the hole 231 of the heat conductive sub-layer 23. Therein, the second electrical conductive layer 24 has insulating parts 241 at two sides of the hole 231 correspondingly; the insulating part 241 is made of a solder resist material; and, the second electrical conductive layer 24 has a thickness between 12 and 180um.

The LED 25 is deposed between the insulating parts 241 at two sides of the second electrical conductive layer 24. And the LED 25 is electrically connected with the second electrical conductive layer 24 through a leading wire 251 at each of the two sides. Thus, a novel diode substrate of a LCD is obtained.

On using, the LED 25 is provided with a required power through the first electrical conductive layer 22 to make the LED 25 emit a required light source. When the LED 25 emits the light source, the LED 25 and the second electrical conductive layer 24 generate heat source simultaneously. At the moment, the heat source is directed to the first electrical conductive layer 22 to be absorbed with a coordination of the heat conductive sub-layer 23. Then the heat source from the first electrical conductive layer 22 is absorbed by the heat conductive layer 21 and is transmitted to the base layer 20 to be dissipated. Thus, a dissipation efficiency of the LCD is well improved.

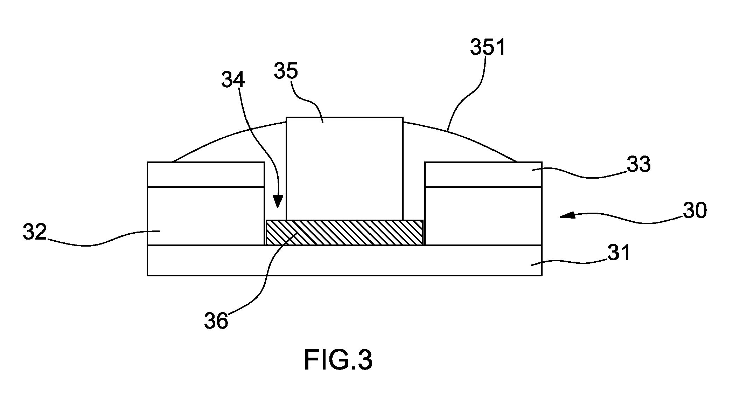

Please refer to FIG.3, which is a sectional view showing a third preferred embodiment. As shown in the figure, the present invention is a diode substrate of a LCD, comprising a substrate 30 and a LED 35, where a process for manufacturing the LCD is simplified and a cost for the LCD is thus reduced.

The substrate 30 comprises a base layer 31; a heat conductive layer 32 on a surface of the base layer 31; and a electrical conductive layer 33 up on a surface of the heat conductive layer 32, where they are piled up to be processed through a hot press. The base layer 31 is an aluminum plate, a copper plate or a copper layer with a thickness between 0.1 and 5mm; the heat conductive layer 32 is made of an insulating heat conductive glue or an insulating glue; the electrical conductive layer 33 is a copper layer with a thickness between 12 and 180um; and, the heat conductive layer 32 and the electrical conductive layer 33 are setup with concaves 34 separately through a laser drilling or a plasma etching corresponding to a surface of the base layer 31.

The LED 35 is put in the concave 34 of the substrate 30 with a solder paste layer 36 between the LED 35 and the base layer 31. And the LED 35 is electrically connected with the electrical conductive layer 33 through a leading wire 351 at each of two sides of the LED 35.

On using, the LED 35 is provided with a required power through the electrical conductive layer 33 to make the LED 35 emit a required light source. When the LED 35 emits the light source, the LED 35 and the electrical conductive layer 33 generate heat source simultaneously. At the moment, the heat source from the LED 35 is transmitted to the base layer 31; and the heat source from the electrical conductive layer 33 is absorbed by the heat conductive layer 32 and is also transmitted to the base layer 31 to be dissipated. Thus, a dissipation efficiency of the LCD is well improved.

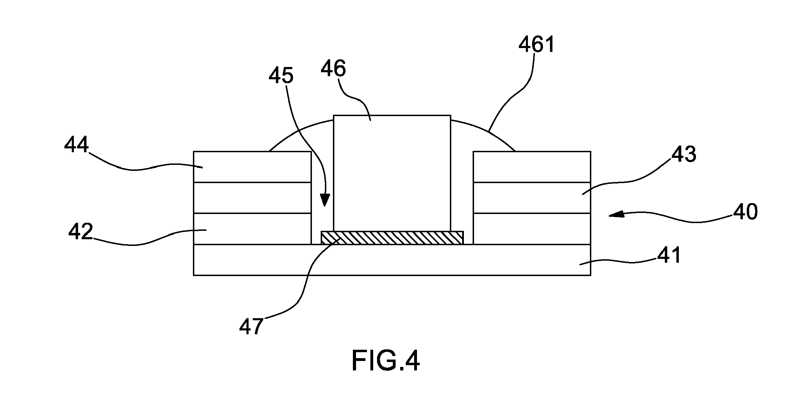

Please refer to FIG.4, which is a sectional view showing a fourth preferred embodiment. As shown in the figure, the present invention is a diode substrate of a LCD, comprising a substrate 40 and a LED 46, where a process for manufacturing the LCD is simplified and a cost for the LCD is thus reduced.

The substrate 40 comprises a base layer 41; a first heat conductive layer 42 on a surface of the base layer 41; a second heat conductive layer 43 on a surface of the first heat conductive layer 42; and a electrical conductive layer 33 on a surface of the second heat conductive layer 43. Therein, the base layer 41 is an aluminum plate, a copper plate or a copper layer with a thickness between 0.1 and 5 mm; the first and the second heat conductive layers 42,43 are made of an insulating heat conductive glue or an insulating glue; the electrical conductive layer 44 is an aluminum plate, a copper plate or a copper layer with a thickness between 12 and 180um; each of the first and the second heat conductive layers 42,43 and the electrical conductive layer 44 is setup with a concave 45 separately through a laser drilling or a plasma etching corresponding to a surface of the base layer 41; and, the base layer 41, the first and the second heat conductive layers 42,43 and the electrical conductive layer 44 are piled up to be processed through a hot press.

The LED 46 is put in the concave 45 of the substrate 40 with a solder paste layer 47 between the LED 46 and the base layer 41. And the LED 46 is electrically connected with the electrical conductive layer 44 through a leading wire 461 at each of two sides of the LED 46.

On using, the LED 46 is provided with a required power through the electrical conductive layer 44 to make the LED 46 emit a required light source. When the LED 46 emits the light source, the LED 46 and the electrical conductive layer 44 generate heat source simultaneously. At the moment, the heat source from the LED 46 is transmitted to the base layer 41 through the solder paste layer 47; and the heat source from the electrical conductive layer 44 is absorbed by the first and the second heat conductive layers 42,43 and is also transmitted to the base layer 41 to be dissipated. Thus, a dissipation efficiency of the LCD is well improved.

To sum up, the present invention is a diode substrate of a LCD, where a dissipation efficiency of the LCD is well improved, a process for manufacturing the LCD is simplified and a cost for the LCD is thus reduced.

The preferred embodiments herein disclosed are not intended to unnecessarily limit the scope of the invention. Therefore, simple modifications or variations belonging to the equivalent of the scope of the claims and the instructions disclosed herein for a patent are all within the scope of the present invention.

## Claims

1. A diode substrate of a liquid crystal display (LCD), comprising:
a base layer;
a heat conductive layer, said heat conductive layer being deposed on a surface of said base layer;
an electrical conductive layer, said electrical conductive layer being deposed on a surface of said heat conductive layer, said electrical conductive layer having two corresponding insulating parts; and
a light emitting diode (LED), said LED being electrically connected with said electrical conductive layer through two leading wires at two sides of said LED separately,
wherein said base layer has a thickness between 0.1 and 5 millimeters;
wherein said electrical conductive layer has a thickness between 12 and 180 micrometers; and
wherein said insulating part is made of a solder resist material.

2. The diode substrate according to claim 1, wherein said base layer is selected from a group consisting of an aluminum plate, a copper plate and a copper layer.

3. The diode substrate according to claim 1 or 2, wherein said heat conductive layer is made of a material selected from a group consisting of an insulating heat conductive glue and an insulating glue.

4. The diode substrate according to one of claims 1 to 3, wherein said electrical conductive layer is a copper layer.

5. The diode substrate according to one of claims 1 to 4, wherein said electrical conductive layer comprises:
a first electrical conductive layer, said first electrical conductive layer being deposed on a surface of said heat conductive layer;
a heat conductive sub-layer, said heat conductive sub-layer being deposed on a surface of said first electrical conductive layer, said heat conductive sub-layer having a hole at center of said heat conductive sub-layer; and
a second electrical conductive layer, said second electrical conductive layer being deposed on a surface of said heat conductive sub-layer, said second electrical conductive layer being connected with said first electrical conductive layer through said hole of said heat conductive sub-layer, said second electrical conductive layer having insulating parts located corresponding to two sides of said hole of said heat conductive sub-layer,
wherein said insulating part is made of a solder resist material.

6. The diode substrate according to claim 5, wherein said first electrical conductive layer and said second electrical conductive layer are copper layers.

7. The diode substrate according to claim 5 or 6, wherein said heat conductive sub-layer is made of a material selected from a group consisting of an insulating heat conductive glue and an insulating glue.

8. A diode substrate of a LCD, comprising:
a substrate, said substrate comprising a base layer, a heat conductive layer on a surface of said base layer, and an electrical conductive layer on a surface of said heat conductive layer, said substrate being obtained through a hot press, said heat conductive layer and said electrical conductive layer separately obtaining a concave corresponding to a surface of said base layer; and
a LED, said LED being deposed in said concave, a solder paste layer being located between said LED and said base layer, said LED being electrically connected with said electrical conductive layer at two sides with a leading wire separately,
wherein said base layer has a thickness between 0.1 and 5mm;
wherein said electrical conductive layer has a thickness between 12 and 180 µm;
wherein said insulating part is made of a solder resist material; and
wherein said concave is obtained through a method selected from a group consisting of a laser drilling or a plasma etching.

9. The diode substrate according to claim 8,wherein said base layer is selected from a group consisting of an aluminum plate, a copper plate and a copper layer.

10. The diode substrate according to claim 8 or 9, wherein said heat conductive layer is made of a material selected from a group consisting of an insulating heat conductive glue and an insulating glue.

11. The diode substrate according to one of claims 8 to 10, wherein said electrical conductive layer is a copper layer.

12. The diode substrate according to one of claims 8 to 11,
wherein said substrate comprises a base layer; a first heat conductive layer deposed on a surface of said base layer; a second heat conductive layer deposed on a surface of said first heat conductive layer; and an electrical conductive layer deposed on a surface of said second heat conductive layer;
wherein each of said first heat conductive layer, said second heat conductive layer and said electrical conductive layer separately obtains a concave corresponding to a surface of said base layer through a method selected from a group consisting of a laser drilling and a plasma etching;
wherein said concave is obtained with a mold; and
wherein said base layer, said first heat conductive layer, said second heat conductive layer and said electrical conductive layer are piled up and processed through a hot press to obtain said substrate.

13. The diode substrate according to claim 12, wherein said base layer is selected from a group consisting of an aluminum plate, a copper plate and a copper layer.

14. The diode substrate according to claim 12 or 13, wherein said first heat conductive layer and said second heat conductive layer is made of a material selected from a group consisting of an insulating heat conductive glue and an insulating glue.

15. The diode substrate according to one of claims 12 to 13, wherein said electrical conductive layer is a copper layer.
